# EUROPEAN PATENT APPLICATION

(11) **EP 4 000 921 A1**
(43) Date of publication of application: **25.05.2022**
(21) Application number: 20841138.9
(22) Date of filing: 06.07.2020
(51) Int. Cl.: B32B 17/10, B60R 11/02, H01L 31/02, H01L 33/56, G09F 9/00, G09F 9/30, G09F 9/33, H01L 27/146, B60J 1/00, B32B 7/025

(54) **TRANSPARENT SENSING DEVICE, LAMINATED GLASS, AND METHOD FOR PRODUCING TRANSPARENT SENSING DEVICE**

(30) Priority: 16.07.2019 JP 2019130927; 04.10.2019 JP 2019183533
(71) Applicant: AGC INC., Chiyoda-ku, Tokyo 1008405 (JP)
(72) Inventor: KOGA, Masahide, Tokyo 100-8405 (JP); TAO, Yukihiro, Tokyo 100-8405 (JP); MITSUI, Yoko, Tokyo 100-8405 (JP)
(74) Representative: Müller-Boré & Partner Patentanwälte PartG mbB
(86) International application number: PCT/JP2020/026469
(87) International publication number: WO 2021/010219

(57) **Abstract**

One embodiment of the present invention is a transparent sensing device comprising: a transparent substrate (10); a microsensor (70) arranged on the transparent substrate (10) and having an area of 250,000 µm² or less; a plurality of wirings (40) connected to the microsensor (70); and a sealing layer (50) covering the microsensor (70) arranged on the transparent substrate (10) and the plurality of wirings (40). The sealing layer (50) is a transparent resin having a water absorption rate of 1% or less after curing. Therefore, it is possible to provide a transparent sensing device in which migration of wirings is suppressed and which has excellent reliability.

## Description

### Technical field

The present invention relates to a transparent sensing device, a laminated glass, and a method for manufacturing a transparent sensing device.

### Background Art

A display device using a light emitting diode (LED) element as a pixel is known. Patent Literature 1 discloses, among such display devices, a transparent display device in which the rear side is visible via the display device. As a related technology, a transparent sensing device in which a microsensor is provided on a transparent substrate is known.

### Citation List

### Patent Literature

[Patent Literature 1] Japanese Unexamined Patent Publication No. 2006-301650

### Summary of Invention

### Technical Problem

The inventors have found the following problems with respect to such a transparent display device and a transparent sensing device.

In such a transparent display device, it is necessary to seal an LED element and a microsensor formed on a transparent substrate and wirings connected to them with a transparent resin. Here, for example, due to moisture contained in the transparent resin or the like, electrochemical migration may occur in the wirings, and the adjacent wirings may be short-circuited. In that case, since at least some LED elements and microsensors do not function normally, there is a problem that the reliability as a transparent display device or a transparent sensing device is inferior.

Hereinafter, "electrochemical migration" is simply referred to as "migration".

### Solution to Problem

The present invention provides a transparent sensing device having the configuration of [1] below.
[1] A transparent sensing device comprising: a transparent substrate; a microsensor arranged on the transparent substrate and having an area of 250,000 µm² or less; a plurality of wirings connected to the microsensor; and a sealing layer covering the microsensor arranged on the transparent substrate and the plurality of wirings, wherein the sealing layer is a transparent resin having a water absorption rate of 1% or less after curing.
   In one aspect of the present invention,
[2] the transparent sensing device according to [1], wherein a peeling adhesive strength between the sealing layer and the plurality of wirings is 1 N/25 mm or more.
[3] The transparent sensing device according to [1] or [2], wherein a peeling adhesive strength between the sealing layer and the transparent substrate is 1 N/25 mm or more.
[4] The transparent sensing device according to any one of [1] to [3], wherein the transparent resin is any one of an olefin-based resin, an acrylic-based resin, and a silicon-based resin.
[5] The transparent sensing device according to [4], wherein the transparent resin is a cycloolefin polymer or a cycloolefin copolymer.
[6] The transparent sensing device according to [4], wherein the transparent resin is a silicone resin.
[7] The transparent sensing device according to any one of [1] to [6], wherein the distance between adjacent wirings in the plurality of wirings arranged on the transparent substrate is 3 to 100 µm.
[8] The transparent sensing device according to any one of [1] to [7], wherein a voltage applied to the plurality of wirings is 1.5 V or more.
[9] The transparent sensing device according to any one of [1] to [8], wherein the plurality of wirings is a metal containing copper or aluminum as a main component.
[10] The transparent sensing device according to any one of [1] to [9], further comprising: at least one light emitting diode element arranged for each pixel on the transparent substrate and having an area of 10,000 µm² or less; and a plurality of display wirings connected to the light emitting diode element, the transparent sensing device thus having a display function, wherein the light emitting diode element and the plurality of display wirings are covered with the sealing layer.
[11] The transparent sensing device according to any one of [1] to [10], wherein the transparent sensing device is mounted on a glazing of a vehicle, and the microsensor monitors at least one of an inside and an outside of the vehicle.
[12] A laminated glass comprising: a pair of glass plates; and a transparent sensing device provided between the pair of glass plates, the transparent sensing device comprising: a transparent substrate; a microsensor arranged on the transparent substrate and having an area of 250,000 µm² or less; a plurality of wirings connected to the microsensor; and a sealing layer covering the microsensor arranged on the transparent substrate and the plurality of wirings, wherein the sealing layer is a transparent resin having a water absorption rate of 1% or less after curing.
[13] The laminated glass according to [12], which is used for a glazing of a vehicle.
[14] The laminated glass according to [13], wherein the microsensor monitors at least one of an inside and an outside of the vehicle.
[15] A method for manufacturing a transparent sensing device, comprising:
   arranging a microsensor having an area of 250,000 µm² or less on a transparent substrate; forming a plurality of wirings connected to the microsensor; and
   forming a sealing layer covering the microsensor arranged on the transparent substrate and the plurality of wirings, wherein the sealing layer is made of a transparent resin having a water absorption rate of 1% or less after curing.

### Advantageous Effects of Invention

According to the present invention, it is possible to provide a transparent sensing device in which migration of wirings is suppressed and which has excellent reliability.

### Brief Description of the Drawings

Fig. 1 is a schematic partial plan view showing an example of a transparent display device according to a first embodiment;
Fig. 2 is a cross-sectional view taken along line II-II in Fig. 1;
Fig. 3 is a cross-sectional view showing an example of a method for manufacturing a transparent display device according to the first embodiment;
Fig. 4 is a cross-sectional view showing an example of a method for manufacturing a transparent display device according to the first embodiment;
Fig. 5 is a cross-sectional view showing an example of a method for manufacturing a transparent display device according to the first embodiment;
Fig. 6 is a cross-sectional view showing an example of a method for manufacturing a transparent display device according to the first embodiment;
Fig. 7 is a cross-sectional view showing an example of a method for manufacturing a transparent display device according to the first embodiment;
Fig. 8 is a cross-sectional view showing an example of a method for manufacturing a transparent display device according to the first embodiment;
Fig. 9 is a cross-sectional view showing an example of a method for manufacturing a transparent display device according to the first embodiment;
Fig. 10 is a cross-sectional view showing an example of a method for manufacturing a transparent display device according to the first embodiment;
Fig. 11 is a schematic plan view showing an example of a laminated glass according to a second embodiment;
Fig. 12 is a schematic partial plan view showing an example of a transparent display device according to a third embodiment;
Fig. 13 is a schematic partial plan view showing an example of a transparent sensing device according to a fourth embodiment;
Fig. 14 is a schematic cross-sectional view of a sensor 70; and
Fig. 15 is a cross-sectional view showing a transparent display device according to Example 2.

### Description of Embodiments

Hereinafter, specific embodiments to which the present invention is applied will be described in detail with reference to the drawings. However, the present invention is not limited to the following embodiments. In order to clarify the explanation, the following description and drawings are simplified as appropriate.

In the present specification, a "transparent display device" refers to a display device in which visual information such as a person and a background located on the rear side of the display device is visible under a desired usage environment. It should be noted that "whether or not visible" is determined at least in a state where the display device is in a non-display state, that is, in a state where the display device is not energized.

Similarly, in the present specification, the "transparent sensing device" refers to a sensing device in which visual information such as a person and a background located on the rear side of the sensing device is visible under a desired usage environment. The "sensing device" refers to a member capable of acquiring various pieces of information using a sensor.

As used herein, the term "transparent" means that the transmittance of visible light is 40% or more, preferably 60% or more, and more preferably 70% or more. It may also indicate that the transmittance is 5% or more and the haze value is 10 or less. If the transmittance is 5% or more, when the outside is viewed from the room during the daytime, the outside can be seen with the same or higher luminance as in the room, and sufficient visibility can be ensured.

When the transmittance is 40% or more, the rear side of the transparent display device is visible substantially without any problem even if the luminance of the front side and the rear side of the transparent display device is approximately the same. When the haze value is 10 or less, the contrast of the background can be sufficiently secured.

The term "transparent" means that it does not matter whether or not a color is given, that is, it may be colorless and transparent, or it may be colored and transparent.

The transmittance refers to a value (%) measured by a method conforming to ISO9050. The haze value refers to a value measured by a method conforming to ISO14782.

### (First Embodiment)

### <Configuration of transparent display device>

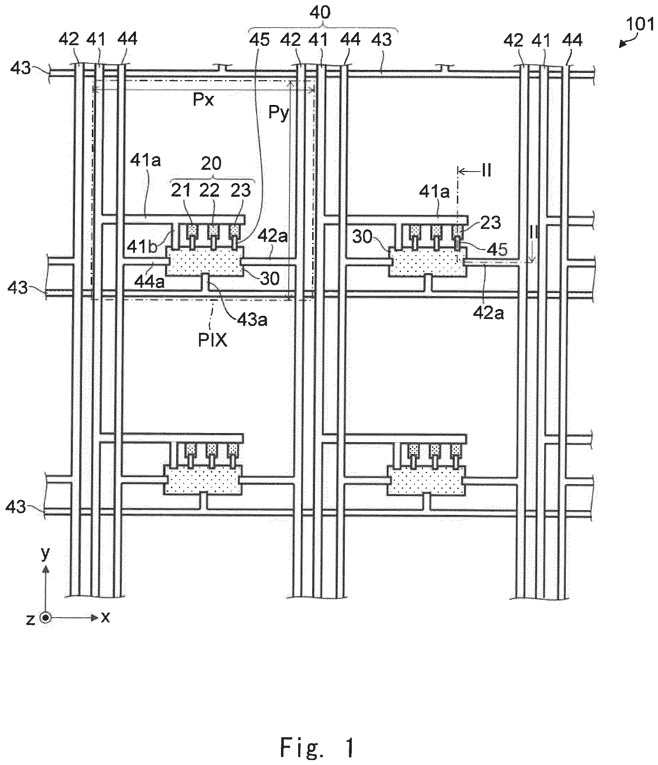

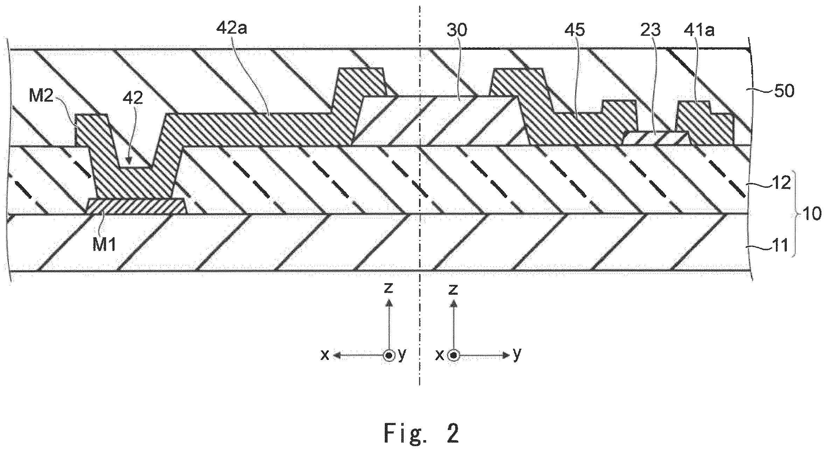

First, the configuration of a transparent display device according to a first embodiment will be described with reference to Figs. 1 and 2. Fig. 1 is a schematic partial plan view showing an example of the transparent display device according to the first embodiment. Fig. 2 is a cross-sectional view taken along line II-II in Fig. 1.

Naturally, the right-handed xyz orthogonal coordinates shown in Figs. 1 and 2 are provided for convenience to explain the positional relationship of the components. Usually, the positive side of the z-axis direction is vertically upward, and the xy-plane is a horizontal plane.

As shown in Figs. 1 and 2, a transparent display device according to the present embodiment includes a transparent substrate 10, light emitting units 20, IC chips 30, wirings 40, and a sealing layer 50. A display region 101 in the transparent display device is a region in which an image is displayed, which is composed of a plurality of pixels. The image includes characters. As shown in Fig. 1, the display region 101 is composed of a plurality of pixels arranged in the row direction (x-axis direction) and the column direction (y-axis direction). Fig. 1 shows a part of the display region 101, and shows a total of 4 pixels, 2 pixels each in the row direction and the column direction. Here, one pixel PIX is shown surrounded by an alternate long and short dash line. In Fig. 1, the transparent substrate 10 and the sealing layer 50 shown in Fig. 2 are omitted. Further, although Fig. 1 is a plan view, the light emitting units 20 and the IC chips 30 are displayed in dots for easy understanding.

### <Planar arrangement of light emitting units 20, IC chips 30, and wirings 40>

First, with reference to Fig. 1, the planar arrangement of the light emitting units 20, the IC (Integrated Circuit) chips 30, and the wirings 40 will be described.

As shown in Fig. 1, the pixels PIX surrounded by the alternate long and short dash line are arranged in a matrix with a pixel pitch Px in the row direction (x-axis direction) and a pixel pitch Py in the column direction (y-axis direction). Here, as shown in Fig. 1, each pixel PIX includes a light emitting unit 20 and an IC chip 30. That is, the light emitting units 20 and the IC chips 30 are arranged in a matrix with the pixel pitch Px in the row direction (x-axis direction) and the pixel pitch Py in the column direction (y-axis direction).

If the pixels are arranged in a predetermined direction at a predetermined pixel pitch, the arrangement format of the pixels PIX, that is, the light emitting units 20 is not limited to the matrix shape.

As shown in Fig. 1, the light emitting unit 20 in each pixel PIX includes at least one light emitting diode element (hereinafter, LED element). That is, the transparent display device according to the present embodiment is a display device that uses an LED element for each pixel PIX, and is called an LED display or the like.

In the example of Fig. 1, each light emitting unit 20 includes a red LED element 21, a green LED element 22, and a blue LED element 23. The LED elements 21 to 23 correspond to sub-pixels constituting one pixel. As described above, since each light emitting unit 20 has the LED elements 21 to 23 that emit light of the colors red, green, and blue, which are the three primary colors of light, the transparent display device according to the present embodiment can display a full-color image.

Each light emitting unit 20 may include two or more LED elements of similar colors. As a result, the dynamic range of the image can be expanded.

The LED elements 21 to 23 have a small size and are so-called micro LED elements. Specifically, the width (length in the x-axis direction) and the length (length in the y-axis direction) of the LED element 21 on the transparent substrate 10 are both, for example, 100 µm or less, preferably 50 µm or less, more preferably 20 µm or less. The same applies to the LED elements 22 and 23. The lower limit of the width and length of the LED element is, for example, 3 µm or more due to various manufacturing conditions and the like.

Although the dimensions, that is, the width and the length of the LED elements 21 to 23 in Fig. 1, are the same, they may be different from each other.

The occupied area of each of the LED elements 21 to 23 on the transparent substrate 10 is, for example, 10,000 µm² or less, preferably 1,000 µm² or less, and more preferably 100 µm² or less. The lower limit of the occupied area of each LED element is, for example, 10 µm² or more due to various manufacturing conditions and the like. Here, in the present specification, the occupied area of the constituent members such as the LED element and the wiring refers to the area in the xy-plan view in Fig. 1.

The shape of the LED elements 21 to 23 shown in Fig. 1 is rectangular, but is not particularly limited. For example, it may be a square, a hexagon, a cone structure, a pillar shape, or the like.

Here, the LED elements 21 to 23 have, for example, a mirror structure for efficiently extracting light to the visible side. Therefore, the transmittance of the LED elements 21 to 23 is as low as about 10% or less, for example. However, in the transparent display device according to the present embodiment, as described above, the LED elements 21 to 23 having a small size having an area of 10,000 µm² or less are used. Therefore, for example, even when the transparent display device is observed from a short distance of about several tens of centimeters to 2 m, the LED elements 21 to 23 are almost invisible. The region with low transmittance in the display region 101 is small, and the visibility on the rear side is excellent. In addition, the degree of freedom in arrangement of the wirings 40 and the like is large.

The "region with low transmittance in the display region 101" is, for example, a region having a transmittance of 20% or less. The same applies hereinafter.

Further, since the LED elements 21 to 23 having a small size are used, the LED elements are not easily damaged even if the transparent display device is curved. Therefore, the transparent display device according to the present embodiment can be used by being attached to a curved transparent plate such as a glazing for vehicles, or being enclosed between two curved transparent plates. Here, if a flexible material is used as the transparent substrate 10, the transparent display device according to the present embodiment can be curved.

The illustrated LED elements 21 to 23 are chip type, but are not particularly limited. The LED elements 21 to 23 may not be packaged with a resin, or may be entirely or partially packaged. The packaging resin may have a lens function to improve the light utilization rate and the efficiency of extracting light to the outside. In that case, the LED elements 21 to 23 may be packaged separately, or a 3-in-1 chip in which three LED elements 21 to 23 are packaged together may be used. Alternatively, although the LED elements emit light at the same wavelength, light having different wavelengths may be extracted depending on a phosphor or the like contained in the packaging resin.

When the LED elements 21 to 23 are packaged, the dimensions and the area of the above-mentioned LED elements are the dimensions and the area in the packaged state. When three LED elements 21 to 23 are packaged together, the area of each LED element is one-third of the total area.

The LED elements 21 to 23 are, but not particularly limited to, inorganic materials, for example. The red LED element 21 is, for example, AlGaAs, GaAsP, GaP, or the like. The green LED element 22 is, for example, InGaN, GaN, AlGaN, GaP, AlGaInP, ZnSe, or the like. The blue LED element 23 is, for example, InGaN, GaN, AlGaN, ZnSe, or the like.

The luminous efficiency, that is, the energy conversion efficiency of the LED elements 21 to 23 is, for example, 1% or more, preferably 5% or more, and more preferably 15% or more. When the luminous efficiency of the LED elements 21 to 23 is 1% or more, sufficient luminance is obtained even with the small-sized LED elements 21 to 23 as described above, and the LED elements 21 to 23 can be used as a display device even during the daytime. When the luminous efficiency of the LED element is 15% or more, heat generation is suppressed, and the LED element can be easily encapsulated inside a laminated glass using a resin adhesive layer.

The LED elements 21 to 23 are obtained by cutting crystals grown by, for example, a liquid phase growth method, an HVPE (Hydride Vapor Phase Epitaxy) method, an MOCVD (Metal Organic Chemical Vapor Deposition) method, or the like. The obtained LED elements 21 to 23 are mounted on the transparent substrate 10.

Alternatively, the LED elements 21 to 23 may be formed by peeling the same from a semiconductor wafer by micro-transfer printing or the like and transferring the same onto the transparent substrate 10.

The pixel pitches Px and Py are both, for example, 100 to 3000 µm, preferably 180 to 1000 µm, and more preferably 250 to 400 µm. By setting the pixel pitches Px and Py in the above-mentioned range, high transparency can be realized while ensuring sufficient display capability. In addition, it is possible to suppress a diffraction phenomenon that may occur due to light from the rear side of the transparent display device.

The pixel density in the display region 101 of the transparent display device according to the present embodiment is, for example, 10 ppi or more, preferably 30 ppi or more, and more preferably 60 ppi or more.

The area of one pixel PIX can be represented by Px×Py. The area of one pixel is, for example, 1 × 10⁴ µm² to 9 × 10⁶ µm², preferably 3 × 10⁴ to 1 × 10⁶ µm², and more preferably 6 × 10⁴ to 2 × 10⁵ µm². By setting the area of one pixel to 1 × 10⁴ µm² to 9 × 10⁶ µm², it is possible to improve the transparency of the display device while ensuring an appropriate display capability. The area of one pixel may be appropriately selected depending on the size of the display region 101, the application, the viewing distance, and the like.

The ratio of the occupied area of the LED elements 21 to 23 to the area of one pixel is, for example, 30% or less, preferably 10% or less, more preferably 5% or less, and further preferably 1% or less. By setting the ratio of the occupied area of the LED elements 21 to 23 to the area of one pixel to 30% or less, the transparency and the visibility on the rear side are improved.

In Fig. 1, in each pixel, three LED elements 21 to 23 are arranged in a row in this order in the x-axis positive direction, but the present invention is not limited to this. For example, the arrangement order of the three LED elements 21 to 23 may be changed. The three LED elements 21 to 23 may be arranged in the y-axis direction. Alternatively, the three LED elements 21 to 23 may be arranged at the vertices of a triangle.

As shown in Fig. 1, when each light emitting unit 20 includes a plurality of LED elements 21 to 23, the distance between the LED elements 21 to 23 in the light emitting unit 20 is, for example, 100 µm or less, preferably 10 µm or less. The LED elements 21 to 23 may be arranged so as to be in contact with each other. As a result, a first power supply branch line 41a can be easily shared, and the aperture ratio can be improved.

In the example of Fig. 1, the arrangement order, arrangement direction, and the like of the plurality of LED elements in each light emitting unit 20 are the same as each other, but may be different. When each light emitting unit 20 includes three LED elements that emit light having different wavelengths, the LED elements in some light emitting units 20 may be arranged side by side in the x-axis direction or the y-axis direction, and the LED elements of respective colors in the other light emitting units 20 may be arranged at the vertices of a triangle.

In the example of Fig. 1, the IC chips 30 are arranged for respective pixels PIX and drive the light emitting units 20. Specifically, the IC chips 30 are connected to the LED elements 21 to 23 via drive lines 45, and can individually drive the LED elements 21 to 23.

The IC chip 30 may be arranged for a plurality of pixels, and drive the plurality of pixels to which each IC chip 30 is connected. For example, if one IC chip 30 is arranged for every four pixels, the number of IC chips 30 can be reduced to 1/4 of the example of Fig. 1, and the occupied area of the IC chips 30 can be reduced.

The area of the IC chip 30 is, for example, 100,000 µm² or less, preferably 10,000 µm² or less, and more preferably 5,000 µm² or less. The transmittance of the IC chip 30 is as low as about 20% or less, but using the IC chip 30 having the above-mentioned size, the region with a low transmittance in the display region 101 becomes smaller, and the visibility on the rear side is improved.

The IC chip 30 is, for example, a hybrid IC having an analog region and a logic region. The analog region includes, for example, a current control circuit, a transformer circuit, and the like.

An LED element with an IC chip in which the LED elements 21 to 23 and the IC chip 30 are resin-sealed together may be used. Further, instead of the IC chip 30, a circuit including a thin film transistor (TFT) may be used. The IC chip 30 is not essential.

On the other hand, a microsensor may be mounted on the IC chip 30. That is, the transparent display device according to the present embodiment may be a transparent sensing device. Details of the microsensor will be described later in the fourth embodiment.

The wirings 40 according to the present embodiment are display wirings, and as shown in Fig. 1, include a plurality of power supply lines 41, a plurality of ground lines 42, a plurality of row data lines 43, a plurality of column data lines 44, and a plurality of drive lines 45.

In the example of Fig. 1, the power supply line 41, the ground line 42, and the column data line 44 extend in the y-axis direction. On the other hand, the row data line 43 extends in the x-axis direction.

In each pixel PIX, the power supply line 41 and the column data line 44 are provided on the x-axis negative side of the light emitting unit 20 and the IC chip 30, and the ground line 42 is provided on the x-axis positive side of the light emitting unit 20 and the IC chip 30. Here, the power supply line 41 is provided on the x-axis negative side of the column data line 44. In each pixel PIX, the row data line 43 is provided on the y-axis negative side of the light emitting unit 20 and the IC chip 30.

As will be described in detail later, as shown in Fig. 1, the power supply line 41 includes a first power supply branch line 41a and a second power supply branch line 41b. The ground line 42 includes a ground branch line 42a. The row data line 43 includes a row data branch line 43a. The column data line 44 includes a column data branch line 44a. Each of these branch lines is included in the wiring 40.

As shown in Fig. 1, each power supply line 41 extending in the y-axis direction is connected to the light emitting unit 20 and the IC chip 30 of each pixel PIX arranged side by side in the y-axis direction. More specifically, in each pixel PIX, the LED elements 21 to 23 are arranged side by side in this order in the x-axis positive direction on the x-axis positive side of the power supply line 41. Therefore, the first power supply branch line 41a branched from the power supply line 41 in the x-axis positive direction is connected to the ends of the LED elements 21 to 23 on the y-axis positive side.

In each pixel PIX, the IC chip 30 is arranged on the y-axis negative side of the LED elements 21 to 23. Therefore, between the LED element 21 and the column data line 44, the second power supply branch line 41b branched from the first power supply branch line 41a in the y-axis negative direction extends linearly and is connected to the x-axis negative side of the end in the y-axis positive side of the IC chip 30.

As shown in Fig. 1, each ground line 42 extending in the y-axis direction is connected to the IC chip 30 of each pixel PIX arranged side by side in the y-axis direction. Specifically, the ground branch line 42a branched from the ground line 42 in the x-axis negative direction extends linearly and is connected to the end on the x-axis positive side of the IC chip 30.

Here, the ground line 42 is connected to the LED elements 21 to 23 via the ground branch line 42a, the IC chip 30, and the drive line 45.

As shown in Fig. 1, each row data line 43 extending in the x-axis direction is connected to the IC chip 30 of each pixel PIX arranged side by side in the x-axis direction (row direction). Specifically, the row data branch line 43a branched from the row data line 43 in the y-axis positive direction extends linearly and is connected to the end on the y-axis negative side of the IC chip 30.

Here, the row data line 43 is connected to the LED elements 21 to 23 via the row data branch line 43a, the IC chip 30, and the drive line 45.

As shown in Fig. 1, each column data line 44 extending in the y-axis direction is connected to the IC chip 30 of each pixel PIX arranged side by side in the y-axis direction (column direction). Specifically, the column data branch line 44a branched from the column data line 44 in the positive direction on the x-axis extends linearly and is connected to the end on the x-axis negative side of the IC chip 30.

Here, the column data line 44 is connected to the LED elements 21 to 23 via the column data branch line 44a, the IC chip 30, and the drive line 45.

In each pixel PIX, the drive line 45 connects the LED elements 21 to 23 and the IC chip 30. Specifically, in each pixel PIX, three drive lines 45 are extended in the y-axis direction, and connect the ends on the y-axis negative side of the LED elements 21 to 23 and the end on the y-axis positive side of the IC chip 30.

The arrangement of the power supply line 41, the ground line 42, the row data line 43, the column data line 44, the branch lines thereof, and the drive line 45 shown in Fig. 1 is merely an example and can be changed as appropriate. For example, at least one of the power supply line 41 and the ground line 42 may extend in the x-axis direction instead of the y-axis direction. The power supply line 41 and the column data line 44 may be interchanged.

The entire configuration shown in Fig. 1 may be inverted vertically or horizontally.

The row data line 43, the column data line 44, the branch lines thereof, and the drive line 45 are not essential.

The wiring 40 is a metal such as copper (Cu), aluminum (Al), silver (Ag), or gold (Au). Of these, a metal containing copper or aluminum as a main component is preferable from the viewpoint of low resistivity and cost. The wiring 40 may be coated with a material such as titanium (Ti), molybdenum (Mo), copper oxide, or carbon for the purpose of reducing the reflectance. The surface of the coated material may have unevenness.

The width of the wiring 40 in the display region 101 shown in Fig. 1 is, for example, 1 to 100 µm, preferably 3 to 20 µm. Since the width of the wiring 40 is 100 µm or less, the wiring 40 is almost invisible even when observing the transparent display device from a short distance of about several tens of centimeters to 2 m, and the visibility on the rear side is excellent. On the other hand, in the case of the thickness range described later, if the width of the wiring 40 is 1 µm or more, an excessive increase in the resistance of the wiring 40 can be suppressed, and a voltage drop and a decrease in signal strength can be suppressed. Further, it is possible to suppress a decrease in heat conduction due to the wiring 40.

Here, as shown in Fig. 1, when the wiring 40 extends mainly in the x-axis direction and the y-axis direction, a cross diffraction image extending in the x-axis direction and the y-axis direction is generated by the light emitted from the outside of the transparent display device and the visibility on the rear side of the transparent display device may be reduced. By reducing the width of each wiring, this diffraction can be suppressed and the visibility on the rear side can be further improved. From the viewpoint of suppressing diffraction, the width of the wiring 40 may be 50 µm or less, preferably 10 µm or less, and more preferably 5 µm or less.

The electrical resistivity of the wiring 40 is, for example, 1.0 × 10⁻⁶ Ωm or less, preferably 2.0 × 10⁻⁸ Ωm or less. The thermal conductivity of the wiring 40 is, for example, 150 to 5,500 W/(m·K), preferably 350 to 450 W/(m·K).

The distance between adjacent wirings 40 in the display region 101 shown in Fig. 1 is, for example, 3 to 100 µm, preferably 5 to 30 µm. If there is a region where the wirings 40 are densely provided, the visibility on the rear side may be obstructed. By setting the distance between adjacent wirings 40 to 3 µm or more, such obstruction of visibility can be prevented. On the other hand, by setting the distance between adjacent wirings 40 to 100 µm or less, sufficient display capability can be ensured.

When the distance between the wirings 40 is not constant due to a curved wiring 40 or the like, the above-mentioned distance between the adjacent wirings 40 indicates the minimum value thereof.

The migration of the wirings 40 is more likely to occur as the electric field strength increases. Here, the electric field strength is defined by "voltage /distance between adjacent wirings 40". Therefore, the larger the voltage applied to the wiring 40 and the smaller the distance between the adjacent wirings 40, the larger the electric field strength and the easier it is for migration to occur. The voltage applied to the wiring 40 is, for example, 1.5 to 5 V. As described above, when the distance between adjacent wirings 40 is 3 to 100 µm, the maximum electric field strength is about 5 V/3 µm = 1,670 kV/m.

The ratio of the occupied area of the wiring 40 to the area of one pixel is, for example, 30% or less, preferably 10% or less, more preferably 5% or less, and further preferably 3% or less. The transmittance of the wiring 40 is as low as 20% or less or 10% or less, for example. However, by setting the ratio of the occupied area of the wiring 40 to 30% or less in one pixel, the region with low transmittance in the display region 101 becomes smaller, and the visibility on the rear side is improved.

The total occupied area of the light emitting unit 20, the IC chip 30, and the wiring 40 with respect to the area of one pixel is, for example, 30% or less, preferably 20% or less, and more preferably 10% or less.

### <Cross-sectional configuration of transparent display device>

Next, with reference to Fig. 2, the cross-sectional configuration of the transparent display device according to the present embodiment will be described.

The transparent substrate 10 is a transparent material having an insulating property. In the example of Fig. 2, the transparent substrate 10 has a two-layer structure including the main base material 11 and the adhesive layer 12.

The main substrate 11 is, for example, a transparent resin, as will be described in detail later.

The adhesive layer 12 is, for example, an epoxy-based, acrylic-based, olefin-based, polyimide-based, or novolac-based transparent resin adhesive.

The main substrate 11 may be a thin glass plate having a thickness of, for example, 200 µm or less, preferably 100 µm or less. The adhesive layer 12 is not essential.

Examples of the transparent resin constituting the main substrate 11 include polyester resins such as polyethylene terephthalate (PET) and polyethylene naphthalate (PEN), olefin resins such as cycloolefin polymer (COP) and cycloolefin copolymer (COC), cellular resins such as cellulose, acetyl cellulose and triacetyl cellulose (TAC), imide resins such as polyimide (PI), vinyl resins such as polyethylene (PE), polyvinyl chloride (PVC), polystyrene (PS), polyvinyl acetate (PVAc), polyvinyl alcohol (PVA) and polyvinyl butyral (PVB), acrylic resins such as polymethyl methacrylate (PMMA) and ethylene vinyl acetate copolymer resin (EVA), and urethane resins.

Among the materials used for the main substrate 11, polyethylene naphthalate (PEN) and polyimide (PI) are preferable from the viewpoint of improving heat resistance. Further, cycloolefin polymer (COP), cycloolefin copolymer (COC), polyvinyl butyral (PVB) and the like are preferable in that the birefringence is low and distortion and bleeding of the image seen through the transparent substrate can be reduced.

One of the above-mentioned materials may be used alone, or two or more kinds of materials may be mixed and used. The main substrate 11 may be formed by laminating flat plates of different materials.

The total thickness of the transparent substrate 10 is, for example, 3 to 1000 µm, preferably 5 to 200 µm. The internal transmittance of visible light of the transparent substrate 10 is, for example, 50% or more, preferably 70% or more, and more preferably 90% or more.

The transparent substrate 10 may have flexibility. In this way, for example, the transparent display device can be mounted on a curved transparent plate, or can be used by being sandwiched between two curved transparent plates. Further, it may be a material that shrinks when heated to 100°C or higher.

As shown in Fig. 2, the LED elements 21 to 23 and the IC chip 30 are provided on the transparent substrate 10, that is, the adhesive layer 12, and are connected to the wiring 40 arranged on the transparent substrate 10. In the example of Fig. 2, the wiring 40 is composed of a first metal layer M1 formed on the main substrate 11 and a second metal layer M2 formed on the adhesive layer 12.

The total thickness of the wiring 40, that is, the thickness of the first metal layer M1 and the thickness of the second metal layer M2 is, for example, 0.1 to 10 µm, preferably 0.5 to 5 µm. The thickness of the first metal layer M1 is, for example, about 0.5 µm, and the thickness of the second metal layer M2 is, for example, about 3 µm.

Specifically, as shown in Fig. 2, since the ground line 42 extending in the y-axis direction carries a large amount of current, the ground line 42 has a two-layer structure including the first metal layer M1 and the second metal layer M2. That is, in the portion where the ground line 42 is provided, the adhesive layer 12 is removed, and the second metal layer M2 is formed on the first metal layer M1. Although not shown in Fig. 2, the power supply line 41, the row data line 43, and the column data line 44 shown in Fig. 1 also have a two-layer structure including the first metal layer M1 and the second metal layer M2.

Here, as shown in Fig. 1, the power supply line 41, the ground line 42, and the column data line 44 extending in the y-axis direction intersect with the row data line 43 extending in the x-axis direction. Although not shown in Fig. 2, at this intersection, the row data line 43 is composed of only the first metal layer M1, and the power supply line 41, the ground line 42, and the column data line 44 are composed of only the second metal layer M2. At this intersection, the adhesive layer 12 is provided between the first metal layer M1 and the second metal layer M2, and the first metal layer M1 and the second metal layer M2 are insulated from each other.

Similarly, at the intersection of the column data line 44 and the first power supply branch line 41a shown in Fig. 1, the first power supply branch line 41a is composed of only the first metal layer M1, and the column data line 44 is composed of only the second metal layer M2.

In the example of Fig. 2, the ground branch line 42a, the drive line 45, and the first power supply branch line 41a are composed of only the second metal layer M2 and are formed so as to cover the ends of the LED elements 21 to 23 and the IC chip 30. Although not shown in Fig. 2, the second power supply branch line 41b, the row data branch line 43a, and the column data branch line 44a are similarly composed of only the second metal layer M2.

As described above, the first power supply branch line 41a is composed of only the first metal layer M1 at the intersection with the column data line 44, and is composed of only the second metal layer M2 in the other portions. Further, a metal pad made of copper, silver, gold or the like may be arranged on the wiring 40 formed on the transparent substrate 10, and at least one of the LED elements 21 to 23 and the IC chip 30 is arranged on the metal pad.

The sealing layer 50 is formed on substantially the entire surface of the transparent substrate 10 so as to cover the light emitting units 20, the IC chips 30, and the wirings 40. The sealing layer 50 is a transparent resin having a water absorption rate of 1% or less after curing. The water absorption rate of the transparent resin after curing is more preferably 0.1% or less, and further preferably 0.01% or less. With such a configuration, migration of the wirings 40 due to moisture in the sealing layer 50 is suppressed, and a highly reliable transparent display device can be provided.

The water absorption rate refers to a value (%) measured by a method conforming to the B method of JIS7209.

The transparent resin constituting the sealing layer 50 is, for example, an olefin-based resin such as a cycloolefin polymer (COP) or a cycloolefin copolymer (COC), an acrylic-based resin such as polymethyl methacrylate (PMMA) or an ethylene vinyl acetate copolymer resin (EVA), a silicon-based resin such as a silicone resin. Further, a transparent resin containing no hydroxyl group (OH group) is preferable because it has a low water absorption rate after curing.

The thickness of the sealing layer 50 is, for example, 3 to 1000 µm, preferably 5 to 200 µm.

The internal transmittance of visible light of the sealing layer 50 is, for example, 50% or more, preferably 70% or more, and more preferably 90% or more.

The peeling adhesive strength between the sealing layer 50 and the transparent substrate 10 is preferably 1 N/25 mm or more. The same applies to the peeling adhesive strength between the sealing layer 50 and the wiring 40. Here, the peeling adhesive strength refers to a value measured by a method conforming to JIS K6854-1 (90° peeling).

From the viewpoint of enhancing the adhesion, the difference between the contact angle of water with respect to the transparent substrate 10 and the contact angle of water with respect to the sealing layer 50 is preferably 30° or less. The same applies to the difference between the contact angle of water with respect to the wiring 40 and the contact angle of water with respect to the sealing layer 50. Here, the contact angle of water refers to a value measured by a method conforming to JIS R3257.

Unevenness may be formed on the surface of the transparent substrate 10 or the wiring 40 so that the adhesion is enhanced by the anchor effect. By increasing the adhesion of the sealing layer 50, it is possible to suppress the migration of the wirings 40 due to the moisture entering from the outside.

As described above, in the transparent display device according to the present embodiment, the sealing layer 50 covering the wirings 40 formed on the transparent substrate 10 is a transparent resin having a water absorption rate of 1% or less after curing. Therefore, migration of the wirings 40 due to moisture in the sealing layer 50 is suppressed, and a highly reliable transparent display device can be provided.

### <Method for manufacturing transparent display device>

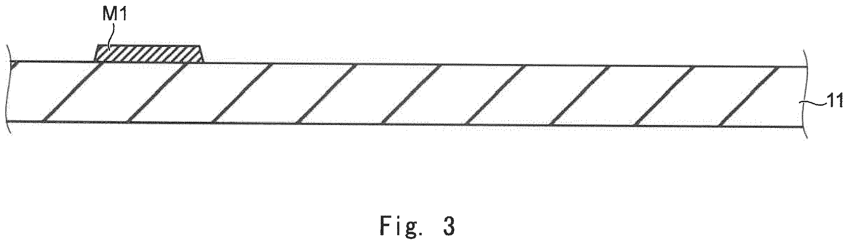

Next, an example of a method for manufacturing the transparent display device according to the first embodiment will be described with reference to Figs. 2 to 10. Figs. 3 to 10 are cross-sectional views showing an example of a method for manufacturing the transparent display device according to the first embodiment. Figs. 3 to 10 are cross-sectional views corresponding to Fig. 2.

First, as shown in Fig. 3, the first metal layer M1 is formed on substantially the entire surface of the main substrate 11, and then the first metal layer M1 is patterned by photolithography to form a lower layer wiring. Specifically, the lower layer wiring is formed by the first metal layer M1 at the position where the power supply line 41, the ground line 42, the row data line 43, the column data line 44, and the like shown in Fig. 1 are formed.

The lower layer wiring is not formed at where the power supply line 41, the ground line 42, and the column data line 44 are intersected by the row data line 43.

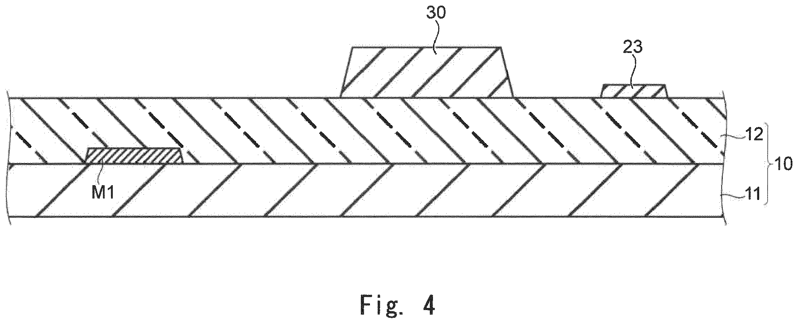

Next, as shown in Fig. 4, after the adhesive layer 12 is formed on substantially the entire surface of the main substrate 11, the LED elements 21 to 23 and the IC chip 30 are mounted on the tacky adhesive layer 12.

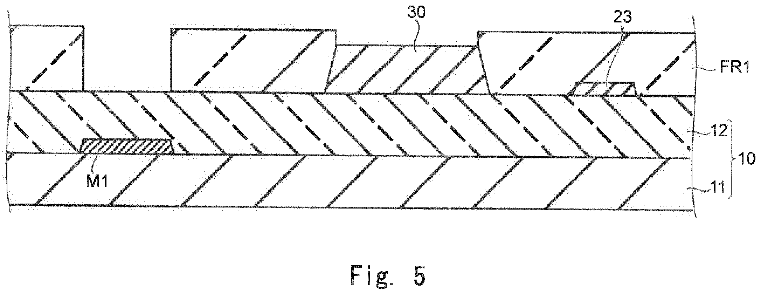

Next, as shown in Fig. 5, a photoresist FR1 is formed on substantially the entire surface of the transparent substrate 10 comprising the main substrate 11 and the adhesive layer 12, and then the photoresist FR1 on the first metal layer M1 is removed by patterning. Here, the photoresist FR1 at which the power supply line 41, the ground line 42, and the column data line 44 are intersected by in the row data line 43 shown in Fig. 1 is not removed.

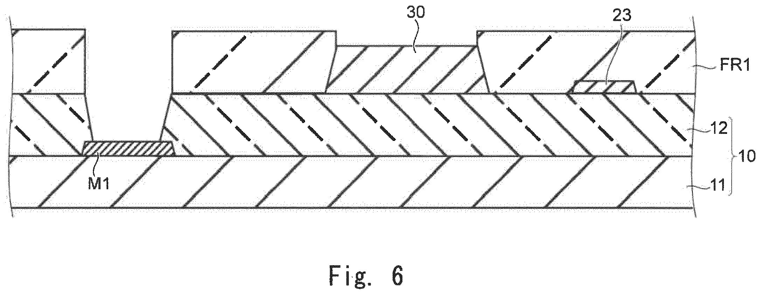

Next, as shown in Fig. 6, the adhesive layer 12 in the portion where the photoresist FR1 has been removed is removed by dry etching to expose the first metal layer M1, that is, the lower layer wiring.

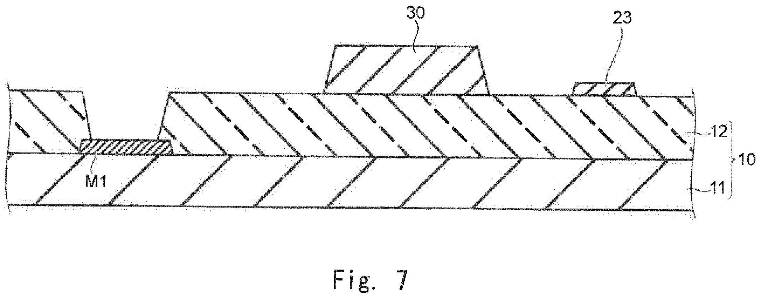

Next, as shown in Fig. 7, the entire photoresist FR1 on the transparent substrate 10 is removed. After that, a seed layer for plating (not shown) is formed on substantially the entire surface of the transparent substrate 10.

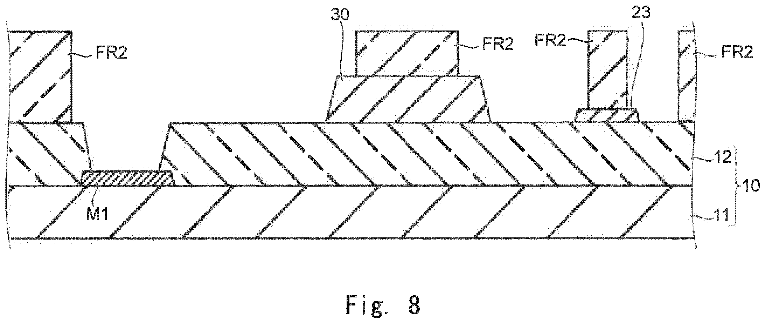

Next, as shown in Fig. 8, after a photoresist FR2 is formed on substantially the entire surface of the transparent substrate 10, the photoresist FR2 in the portion where the upper layer wiring is formed is removed by patterning to expose the seed layer.

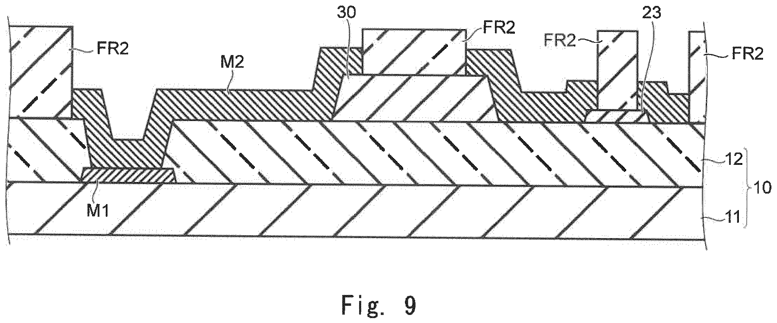

Next, as shown in Fig. 9, the second metal layer M2 is formed by plating on the portion where the photoresist FR2 has been removed, that is, on the seed layer. As a result, the upper layer wiring is formed by the second metal layer M2.

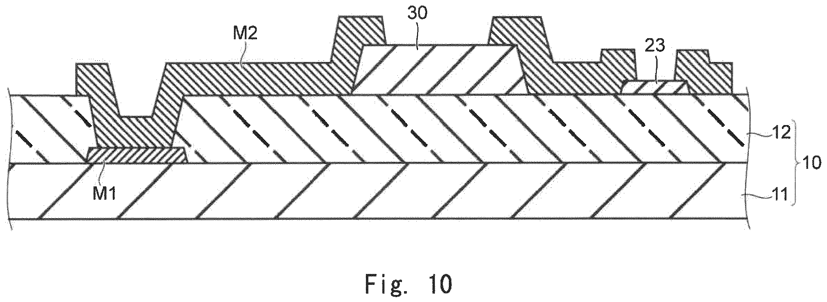

Next, as shown in Fig. 10, the photoresist FR2 is removed. The seed layer exposed by the removal of the photoresist FR2 is removed by etching.

Finally, as shown in Fig. 2, a transparent display device is obtained by forming the sealing layer 50 on substantially the entire surface of the transparent substrate 10.

### (Second Embodiment)

### <Configuration of laminated glass having transparent display device>

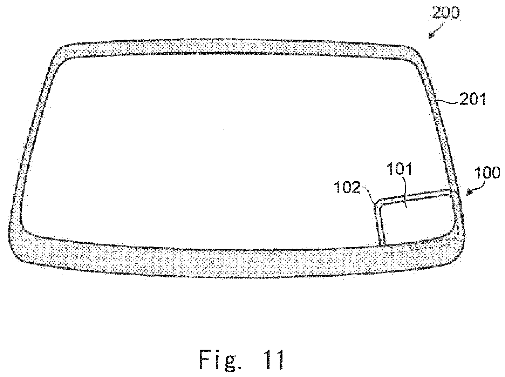

Next, the configuration of a laminated glass according to a second embodiment will be described with reference to Fig. 11. Fig. 11 is a schematic plan view showing an example of the laminated glass according to the second embodiment. As shown in Fig. 11, a laminated glass 200 according to the second embodiment is formed by laminating a pair of glass plates, and includes the transparent display device 100 according to the first embodiment between the pair of glass plates. The laminated glass 200 shown in Fig. 11 is used for the windshield of the glazing of a vehicle, but is not particularly limited to the use.

As shown in Fig. 11, for example, a black shielding portion 201 is provided on the entire peripheral edge of the laminated glass 200. The shielding portion 201 blocks sunlight and protects the adhesive for assembling the laminated glass 200 to the vehicle from ultraviolet rays. In addition, the shielding portion 201 makes the adhesive invisible from the outside.

As shown in Fig. 11, the transparent display device 100 includes a non-display region 102 provided around the display region in addition to the display region 101 shown in Fig. 1. Here, as described in the first embodiment, the display region 101 is a region composed of a large number of pixels and in which an image is displayed, and therefore detailed description thereof will be omitted.

Although Fig. 11 is a plan view, the non-display region 102 and the shielding portion 201 are displayed in dots for easy understanding.

The non-display region 102 is a region that does not include pixels and does not display an image. In the non-display region 102, wide wirings connected to the power supply line 41, the ground line 42, the row data line 43, and the column data line 44 shown in Fig. 1 are densely provided. The width of the wiring in the non-display region 102 is, for example, 100 to 10,000 µm, preferably 100 to 5,000 µm. The distance between the wirings is, for example, 3 to 5,000 µm, preferably 50 to 1,500 µm.

Therefore, while the display region 101 is transparent, the non-display region 102 is opaque and will be visible from the inside of the vehicle. Here, if the non-display region 102 is visible, the aesthetic appearance of the laminated glass 200 deteriorates. Therefore, in the laminated glass 200 according to the second embodiment, at least a portion of the non-display region 102 of the transparent display device 100 is provided in the shielding portion 201. The non-display region 102 provided in the shielding portion 201 is concealed by the shielding portion 201 and is invisible. Therefore, the aesthetic appearance of the laminated glass 200 is improved as compared with the case where the entire non-display region 102 is visible.

### (Third Embodiment)

### <Configuration of transparent display device>

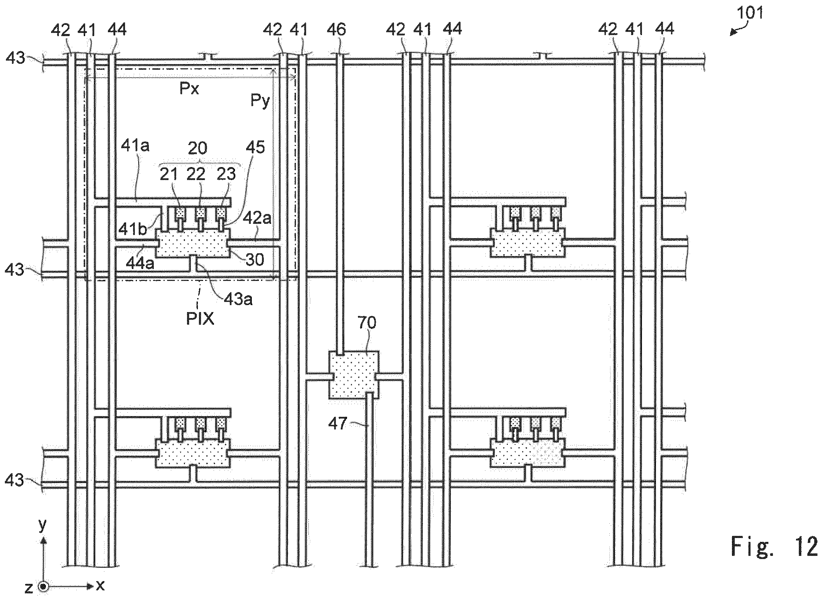

Next, the configuration of a transparent display device according to a third embodiment will be described with reference to Fig. 12. Fig. 12 is a schematic partial plan view showing an example of the transparent display device according to the third embodiment. As shown in Fig. 12, the transparent display device according to the present embodiment includes a sensor 70 in the display region 101 in addition to the configuration of the transparent display device according to the first embodiment shown in Fig. 1.

In the example shown in Fig. 12, the sensor 70 is provided between the predetermined pixels PIX and is connected to the power supply line 41 and the ground line 42. The data detected by the sensor 70 is output via the data output line 46 extending from the sensor 70 in the y-axis direction. On the other hand, a control signal is input to the sensor 70 via a control signal line 47 extending in the y-axis direction to the sensor 70, and the sensor 70 is controlled. The number of sensors 70 may be singular or plural. A plurality of sensors 70 may be arranged at predetermined intervals, for example, in the x-axis direction or the y-axis direction.

In the following description, a case where the transparent display device according to the present embodiment is mounted on the windshield of the glazing of a vehicle will be described. That is, the transparent display device according to the present embodiment can also be applied to the laminated glass according to the second embodiment.

The sensor 70 is, for example, an illuminance sensor (for example, a light receiving element) for detecting illuminance inside and outside the vehicle. For example, the luminance of the display region 101 by the LED elements 21 to 23 is controlled according to the illuminance detected by the sensor 70. For example, the greater the illuminance outside the vehicle than the illuminance inside the vehicle, the greater the luminance of the display region 101 by the LED elements 21 to 23. With such a configuration, the visibility of the transparent display device is further improved.

The sensor 70 may be an infrared sensor (for example, a light receiving element) or an image sensor (for example, a CMOS (Complementary Metal-Oxide-Semiconductor) image sensor) for detecting the line of sight of an observer (for example, a driver). For example, the transparent display device is driven only when the sensor 70 senses the line of sight. For example, the transparent display device is preferably used for the laminated glass shown in Fig. 11 because the transparent display device does not block the observer's view unless the observer directs his/her line of sight toward the transparent display device. Alternatively, the sensor 70, which is an image sensor, may detect the movement of the observer, and the transparent display device may be turned on and off or the display screen may be switched based on the movement, for example.

Other configurations are the same as those of the transparent display device according to the first embodiment.

### (Fourth Embodiment)

### <Configuration of transparent sensing device>

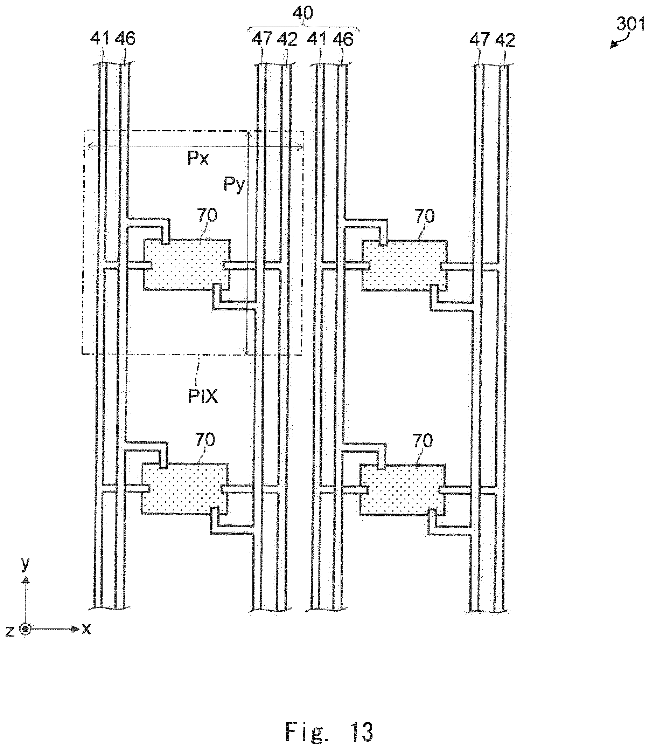

Next, the configuration of a transparent sensing device according to a fourth embodiment will be described with reference to Fig. 13. Fig. 13 is a schematic partial plan view showing an example of the transparent sensing device according to the fourth embodiment. As shown in Fig. 13, the transparent sensing device according to the present embodiment has a configuration in which a sensor 70 is provided in each pixel PIX instead of the light emitting unit 20 and the IC chip 30 in the configuration of the transparent display device according to the first embodiment shown in Fig. 1. That is, the transparent sensing device shown in Fig. 13 does not have the light emitting unit 20 and does not have a display function.

The sensor 70 is not particularly limited, and is a CMOS image sensor in the transparent sensing device shown in Fig. 13. That is, the transparent sensing device shown in Fig. 13 includes an imaging region 301 composed of a plurality of pixels PIX arranged in the row direction (x-axis direction) and the column direction (y-axis direction), and has an imaging function. Fig. 13 shows a part of the imaging region 301, and shows a total of 4 pixels, 2 pixels each in the row direction and the column direction. Here, one pixel PIX is shown surrounded by an alternate long and short dash line. In Fig. 13, the transparent substrate 10 and the sealing layer 50 are omitted as in Fig. 1. Further, although Fig. 13 is a plan view, the sensors 70 are displayed in dots for easy understanding.

In the example shown in Fig. 13, one sensor 70 is provided for each pixel PIX, is arranged between the power supply line 41 and the ground line 42 extending in the y-axis direction, and is connected to both. The data detected by the sensor 70 is output via the data output line 46 extending from the sensor 70 in the y-axis direction. On the other hand, a control signal is input to the sensor 70 via a control signal line 47 extending in the y-axis direction to the sensor 70, and the sensor 70 is controlled. The control signal is, for example, a synchronization signal, a reset signal, or the like.

The power supply line 41 may be connected to a battery (not shown).

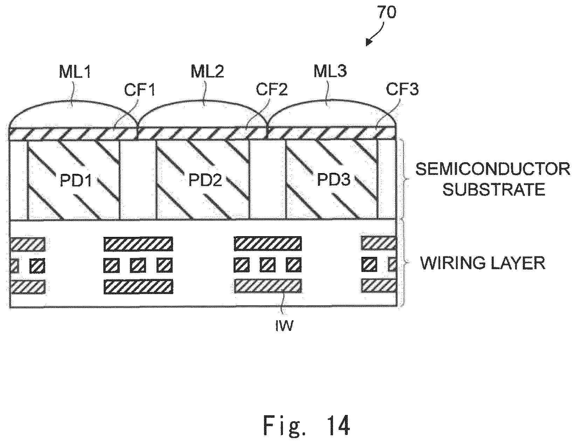

Here, Fig. 14 is a schematic cross-sectional view of the sensor 70. The sensor 70 shown in Fig. 14 is a back-illuminated CMOS image sensor. The sensor 70 as an image sensor is not particularly limited, and a front-illuminated CMOS image sensor or a CCD (Charge-Coupled Device) image sensor may be used.

As shown in Fig. 14, each sensor 70 includes a wiring layer, a semiconductor substrate, color filters CF1 to CF3, and microlenses ML1 to ML3. Here, an internal wiring IW is formed inside the wiring layer. Further, photodiodes PD1 to PD3 are formed inside the semiconductor substrate.

A semiconductor substrate (for example, a silicon substrate) is formed on the wiring layer. The internal wiring IW formed inside the wiring layer connects the wirings 40 (power supply line 41, ground line 42, data output line 46, and control signal line 47) and the photodiodes PD1 to PD3. When the photodiodes PD1 to PD3 are irradiated with light, a current is output from the photodiodes PD1 to PD3. The currents output from the photodiodes PD1 to PD3 are amplified by an amplifier circuit (not shown) and output via the internal wiring IW and the data output line 46.

The color filters CF1 to CF3 are formed on the photodiodes PD1 to PD3 formed inside the semiconductor substrate, respectively. The color filters CF1 to CF3 are, for example, a red filter, a green filter, and a blue filter, respectively.

The microlenses ML1 to ML3 are placed on the color filters CF1 to CF3, respectively. The light collected by the microlenses ML1 to ML3, which are convex lenses, is incident on the photodiodes PD1 to PD3 via the color filters CF1 to CF3, respectively.

The sensor 70 according to the present embodiment is a microsensor having a small size having an occupied area of 250,000 µm² or less on the transparent substrate 10. In other words, in the present specification, the microsensor is a sensor having a small size having an area of 250,000 µm² or less in a plan view. The occupied area of the sensor 70 is, for example, preferably 25,000 µm² or less, more preferably 2,500 µm² or less. The lower limit of the occupied area of the sensor 70 is, for example, 10 µm² or more due to various manufacturing conditions and the like.

The shape of the sensor 70 shown in Fig. 13 is rectangular, but is not particularly limited.

The transparent sensing device according to the present embodiment can also be applied to the laminated glass according to the second embodiment. When the transparent sensing device according to the present embodiment is mounted on the windshield of the glazing of a vehicle (for example, a vehicle), the sensor 70 can acquire an image of at least one of the inside and outside the vehicle, for example. That is, the transparent sensing device according to the present embodiment has a function as a drive recorder.

The number of sensors 70 in the transparent sensing device according to the fourth embodiment may be singular. The sensor 70 in the transparent sensing device according to the fourth embodiment is not limited to the image sensor, and may be an illuminance sensor, an infrared sensor, or the like exemplified in the third embodiment. The sensor 70 may be a radar sensor, a LIDAR sensor, or the like. For example, the inside and outside of a vehicle can be monitored by a glazing for vehicles equipped with a transparent sensing device using these sensors 70.

That is, the sensor 70 according to the fourth embodiment is not particularly limited as long as it is a microsensor having a small size having an occupied area of 250,000 µm² or less on the transparent substrate 10. For example, the sensor 70 may be a temperature sensor, an ultraviolet sensor, a radio wave sensor, a pressure sensor, a sound sensor, a speed/acceleration sensor, or the like.

Other configurations are the same as those of the transparent display device according to the first embodiment.

### [Example]

Examples of the present invention are shown below, but the present invention is not construed as being limited to the following examples.

The transparent display devices according to Examples 1 and 2 were subjected to a continuous energization test under high-temperature and high-humidity environment of a temperature of 65°C and a humidity of 85%, and changes in luminance before and after the test were examined. Examples 1 and 2 are examples of the present invention.

First, a method for manufacturing the transparent display device according to Example 1 will be described with reference to Figs. 2 to 10.

### <Example 1>

The method for manufacturing the transparent display device according to Example 1 will be described below.

As shown in Fig. 3, using a glass plate (AN-100 manufactured by AGC Inc.) having a thickness of 0.7 mm as the main substrate 11, the first metal layer M1 having a three-layer structure including a Ti film having a thickness of 0.04 µm, a Cu film having a thickness of 0.60 µm, and a Ti film having a thickness of 0.10 µm was formed in this order on substantially the entire surface of the main substrate 11. Then, the first metal layer M1 was patterned by photolithography to form a lower layer wiring.

Next, as shown in Fig. 4, the adhesive layer 12 which is an epoxy resin (InterVia 8023 manufactured by DowDuPont) was formed on substantially the entire surface of the main substrate 11, and then the LED elements 21 to 23 and the IC chip 30 were mounted on the tacky adhesive layer 12.

Next, as shown in Fig. 5, after the photoresist FR1 was formed on substantially the entire surface of the transparent substrate 10 including the main substrate 11 and the adhesive layer 12, the photoresist FR1 on the first metal layer M1 and the IC chip 30 was removed by patterning.

Next, as shown in Fig. 6, the adhesive layer 12 in the portion where the photoresist FR1 had been removed was removed by dry etching to expose the first metal layer M1, that is, the lower layer wiring.

Next, as shown in Fig. 7, the entire photoresist FR1 on the transparent substrate 10 was removed. Then, a seed layer for plating containing a W-10Ti alloy film having a thickness of 0.1 µm and a Cu film having a thickness of 0.15 µm was formed on substantially the entire surface of the transparent substrate 10.

Next, as shown in Fig. 8, after the photoresist FR2 was formed on substantially the entire surface of the transparent substrate 10, the photoresist FR2 in the portion where the upper layer wiring had been formed was removed by patterning to expose the seed layer.

Next, as shown in Fig. 9, the second metal layer M2 having a thickness of 3.0 µm containing Cu was formed as an upper layer wiring by plating on the portion where the photoresist FR2 had been removed, that is, on the seed layer.

Next, as shown in Fig. 10, the photoresist FR2 was removed. The seed layer exposed by the removal of the photoresist FR2 was removed by etching.

Finally, as shown in Fig. 2, a silicone elastomer (Sylgard 184 manufactured by Dow Corning Toray Co., Ltd.) was applied by potting on substantially the entire surface of the transparent substrate 10 to form the sealing layer 50. Then, it was held at room temperature for 48 hours, and the sealing layer 50 was cured. In this way, the transparent display device according to Example 1 was manufactured.

The water absorption rate of the sealing layer 50 in the transparent display device according to Example 1 was 0.06%.

In the transparent display device according to Example 1, the luminance before the continuous energization test was 181 cd/m², whereas the luminance after the test was 115 cd/m², the luminance decrease was only 36%, and the lumen maintenance was 50% or more of the initial value. It is presumed that since the water absorption rate of the sealing layer 50 was low, migration was able to be suppressed.

### <Example 2>

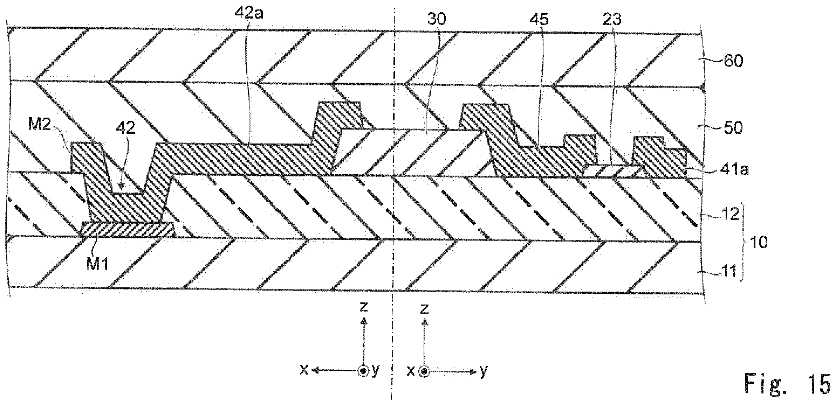

Next, a method for manufacturing the transparent display device according to Example 2 will be described with reference to Fig. 15.

Fig. 15 is a cross-sectional view showing a transparent display device according to Example 2. Fig. 15 is a cross-sectional view corresponding to Fig. 2. As shown in Fig. 15, in the transparent display device according to Example 2, a glass plate 60 is provided on the sealing layer 50. That is, the glass main substrate 11 and the glass plate 60 are laminated and vitrified by the sealing layer 50. In the transparent display device according to Example 2, a cycloolefin polymer (COP) film (Zeonoa film ZF14 manufactured by Zeon Corporation) was used as the sealing layer 50.

Since the steps shown in Figs. 3 to 10, that is, the steps prior to the step of forming the sealing layer 50 shown in Fig. 15, are the same as those in Example 1, the description thereof will be omitted.

Next, as shown in Fig. 15, in order to form the sealing layer 50, substantially the entire surface of the transparent substrate 10 was covered with a COP film having a thickness of 0.762 mm, and the COP film was further covered with a glass plate 60 having a thickness of 1.8 mm (float glass manufactured by AGC Inc.). That is, the COP film for the sealing layer 50 was sandwiched between the transparent substrate 10 and the glass plate 60.

Subsequently, the pressure was reduced to 5 Pa or less, and under the reduced pressure, the COP film was heated for 1 hour at 100°C, which is near the glass transition temperature Tg of the COP film, and the COP film was temporarily pressure-bonded to the transparent substrate 10 and the glass plate 60.

The transparent display device according to Example 2 was manufactured by heating in an autoclave device at 10 atm and 130°C for 20 minutes.

The transparent display device according to Example 2 shown in Fig. 15 has a configuration in which the transparent display device is provided on a laminated glass sandwiched between a pair of glass plates (transparent substrate 10 and glass plate 60), and is a modified example of the laminated glass according to the second embodiment. That is, the transparent substrate 10 may form one of a pair of glass plates. The cross-sectional configuration of the laminated glass according to the second embodiment shown in Fig. 11 is a configuration in which another glass plate is further provided on the outer side (the lower side of the drawing) of the transparent substrate 10 in Fig. 15.

The water absorption rate of the sealing layer 50 in the transparent display device according to Example 2 was less than 0.01%.

In the transparent display device according to Example 2, the luminance before the continuous energization test was 121 cd/m², whereas the luminance after the test was 118 cd/m², and the luminance decrease was only 2.5%. That is, the lumen maintenance was 95% or more of the initial value, which was an extremely good result. It is presumed that since the water absorption rate of the sealing layer 50 was extremely low, migration was able to be dramatically suppressed.

The present invention is not limited to the above-described embodiments, and can be appropriately modified without departing from the spirit.

For example, the transparent display device may have a touch panel function.

This application claims priority to and the benefit from Japanese Patent Application 2019-130927 filed on July 16, 2019 and Japanese Patent Application No. 2019-183533 filed on October 4, 2019, the entire contents of which are hereby incorporated.

### Reference Signs List

10 TRANSPARENT SUBSTRATE
11 MAIN SUBSTRATE
12 ADHESIVE LAYER
20 LIGHT EMITTING UNIT
21 to 23 LED ELEMENT
30 IC CHIP
40 WIRING
41 POWER SUPPLY LINE
41a FIRST POWER SUPPLY BRANCH LINE
41b SECOND POWER SUPPLY BRANCH LINE
42 GROUND LINE
42a GROUND BRANCH LINE
43 ROW DATA LINE
43 a ROW DATA BRANCH LINE
44 COLUMN DATA LINE
44a COLUMN DATA BRANCH LINE
45 DRIVE LINE
46 DATA OUTPUT LINE
47 CONTROL SIGNAL LINE
50 SEALING LAYER
60 GLASS PLATE
70 SENSOR
100 TRANSPARENT DISPLAY DEVICE
101 DISPLAY REGION
102 NON-DISPLAY REGION
200 LAMINATED GLASS (GLAZING)
201 SHIELDING PORTION
CF1 to CF3 COLOR FILTER
FR1, FR2 PHOTORESIST
IW INTERNAL WIRING
M1 FIRST METAL LAYER
M2 SECOND METAL LAYER
ML1 to ML3 MICROLENS
PD1 to PD3 PHOTODIODE
PIX PIXEL

## Claims

1. A transparent sensing device comprising:
a transparent substrate;
a microsensor arranged on the transparent substrate and having an area of 250,000 µm² or less;
a plurality of wirings connected to the microsensor; and
a sealing layer covering the microsensor arranged on the transparent substrate and the plurality of wirings,
wherein the sealing layer is a transparent resin having a water absorption rate of 1% or less after curing.

2. The transparent sensing device according to Claim 1, wherein a peeling adhesive strength between the sealing layer and the plurality of wirings is 1 N/25 mm or more.

3. The transparent sensing device according to Claim 1 or 2, wherein a peeling adhesive strength between the sealing layer and the transparent substrate is 1 N/25 mm or more.

4. The transparent sensing device according to any one of Claims 1 to 3, wherein the transparent resin is any one of an olefin-based resin, an acrylic-based resin, and a silicon-based resin.

5. The transparent sensing device according to Claim 4, wherein the transparent resin is a cycloolefin polymer or a cycloolefin copolymer.

6. The transparent sensing device according to Claim 4, wherein the transparent resin is a silicone resin.

7. The transparent sensing device according to any one of Claims 1 to 6, wherein a distance between adjacent wirings in the plurality of wirings arranged on the transparent substrate is 3 to 100 µm.

8. The transparent sensing device according to any one of Claims 1 to 7, wherein a voltage applied to the plurality of wirings is 1.5 V or more.

9. The transparent sensing device according to any one of Claims 1 to 8, wherein the plurality of wirings is a metal containing copper or aluminum as a main component.

10. The transparent sensing device according to any one of Claims 1 to 9, further comprising:
at least one light emitting diode element arranged for each pixel on the transparent substrate and having an area of 10,000 µm² or less; and
a plurality of display wirings connected to the light emitting diode element, the transparent sensing device thus having a display function,
wherein the light emitting diode element and the plurality of display wirings are covered with the sealing layer.

11. The transparent sensing device according to any one of Claims 1 to 10, wherein the transparent sensing device is mounted on a glazing of a vehicle, and
the microsensor monitors at least one of an inside and an outside of the vehicle.

12. A laminated glass comprising:
a pair of glass plates; and
a transparent sensing device provided between the pair of glass plates, the transparent sensing device comprising:
a transparent substrate;
a microsensor arranged on the transparent substrate and having an area of 250,000 µm² or less;
a plurality of wirings connected to the microsensor; and
a sealing layer covering the microsensor arranged on the transparent substrate and the plurality of wirings,
wherein the sealing layer is a transparent resin having a water absorption rate of 1% or less after curing.

13. The laminated glass according to Claim 12, wherein the laminated glass is used for a glazing of a vehicle.

14. The laminated glass according to Claim 13, wherein the microsensor monitors at least one of an inside and an outside of the vehicle.

15. A method for manufacturing a transparent sensing device, comprising:
arranging a microsensor having an area of 250,000 µm² or less on a transparent substrate;
forming a plurality of wirings connected to the microsensor; and
forming a sealing layer covering the microsensor arranged on the transparent substrate and the plurality of wirings,
wherein the sealing layer is made of a transparent resin having a water absorption rate of 1% or less after curing.
